# EUROPEAN PATENT APPLICATION

(11) **EP 1 117 129 A2**
(43) Date of publication of application: **18.07.2001**
(21) Application number: 00128680.6
(22) Date of filing: 29.12.2000
(51) Int. Cl.: H01L 21/66, H01L 21/00

(54) **Semiconductor wafer inspection machine**

(30) Priority: 12.01.2000 JP 2000003546
(71) Applicant: TOKYO SEIMITSU CO.,LTD., Mitaka-shi Tokyo (JP)
(72) Inventor: Arai, Masatoshi, c/o Tokyo Seimitsu Co., Ltd., Mitaka-shi, Tokyo (JP); Sakai, Makoto, c/o Tokyo Seimitsu Co., Ltd., Mitaka-shi, Tokyo (JP)
(74) Representative: Rapp, Bertram, Dr.

(57) **Abstract**

The semiconductor wafer inspection machine, which can measure the alignment marks positioned at different focal points in a short time with a high precision, without deteriorating the throughput, is disclosed. The semiconductor wafer inspection machine forms an optical image of the semiconductor wafer surface, on which the first layer having the first alignment mark and the second layer having the second alignment mark are formed, and is equipped with the confocal optical system, in which the focal point differs depending on the wavelength and an optical image of the semiconductor surface is formed, and the light source of the confocal optical system has a wide range of wavelengths. In the confocal optical system, only the image at the focal point is projected clearly and other images at points out of focus are excluded. Therefore, if the confocal optical system is designed so that the focal point differs depending on wavelength, the image at each focal point corresponding to each wavelength can be formed clearly. As a result, if a light source having a wide range of wavelengths is used, a clear image at each focal point can be obtained successively, in other words, clear images can be obtained at a wide range of focal points.

## Description

### BACKGROUND OF THE INVENTION

This invention relates to a semiconductor wafer inspection machine and, more particularly, to a semiconductor wafer inspection machine able to examine the physical relationship of the alignment marks of the lower and upper process layers to confirm that the positions in which process layers are formed is correct, when forming another process layer an a semiconductor wafer an which a process layer has already been formed.

There is a general trend that the number of layers of a semiconductor device increases as its density increases, and there are hundreds of steps in a manufacturing process for a semiconductor device. Before each process layer is formed, a patterned resist layer is formed by exposing and developing a pattern on a coated resist. Each process layer is machined into a patterned layer corresponding to a resist pattern by etching or sputtering. The patterns of each process layer are very small in a high density semiconductor device, and the precision of registration of each process pattern must be very accurate. Moreover, the number of process layers is increasing, and if a semiconductor device has a process layer with a position error which is large, the semiconductor device will be a poor product.

Therefore it is necessary to confirm that the error in position is within an allowable range by measuring the difference in position between a patterned resist layer and a process layer thereunder. When the error in position is within an allowable range, the process layer is machined using the resist layer, and if the error is out of the range, the resist layer is removed and it is necessary to start the process of forming a resist layer again. The result of the measured error in position is fed back to a stepper, which is an exposure apparatus, and used when the position is adjusted during exposure.

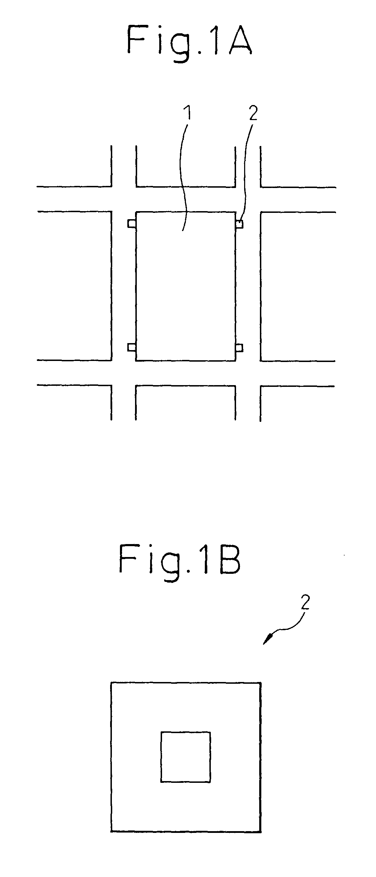

To measure the error in position, alignment marks 2 are formed for each process layer around a die 1 formed on the wafer, and the physical relationship of the alignment marks of the two layers is measured. The shape of the alignment mark is used according to the SEMI Standard P25-96 (Overlay measuring test patterns for manufacturing integrated circuits.) FIG.1B illustrates an example of such an alignment mark, called Box-in-box.

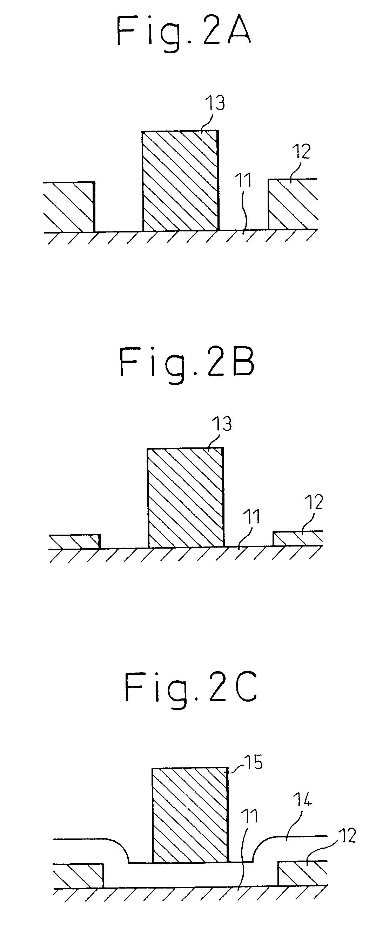

FIGs.2A through 2C illustrate examples of the cross-sectional shape of the alignment mark. FIG.2A is an example when forming a first process layer 12 on the base substrate or a lower process layer 11, and forming a resist layer 13 thereon. A square aperture is formed as a first alignment mark on the first process layer 12, and the square resist layer 13 is formed in the center of the aperture. The image of this part of the mark is projected to a video camera through a microscope or the like, and the difference in position of the center of the two marks is measured by examining the image on a monitor or the like. It is common to provide an image processor to process the video signal from the video camera and to measure the difference in position of the center of the two marks automatically.

FIG.2B is an example when the film of the first process layer 12 is thin. In this case, the difference in level between the top surface of the first process layer 12 and that of the resist layer 13 is larger than that in FIG.2A, therefore, a lens with a large depth of focus is necessary, and since the difference in level is small in the first alignment marks, it is more difficult to measure the position of the mark accurately compared to that in FIG.2A.

FIG.2C is an example when a second process layer 14 is deposited evenly on the first process layer 12 having the first alignment mark of square aperture, and a patterned resist layer 15 is formed thereon. The second process layer 14 is machined into a pattern of the resist layer 15 in the next process. In this case, since the second process layer 14 is deposited on the first process layer 12, an edge corresponding to the first alignment mark, is formed on the second process layer 14. In this process, the center of the first position alignment mark may be determined by measuring the edge of the second process layer 14, or the center of the first position alignment mark of the first process layer 12 may be measured through the second process layer 14.

In either way, it is very difficult to measure the center of the alignment marks shown in FIGs.2B or 2C accurately compared to the measurement of the alignment mark in FIG.2A.

Recently, the minimum line width of a pattern has become narrower as the density of semiconductor device has increased, and the allowable range for the precision of the registration is smaller, leading to a demand for the measurement of the center of the position alignment mark to be made with high precision. It is necessary to use an optical system having high resolution for the measurement of the alignment mark center with a high precision. Though a microscopic lens (objective) with a large NA (Numerical Aperture) is required for high resolution, the depth of focus is narrow when NA is large.

For example, if the alignment marks are those as shown in FIG.2A, the difference in height between the first process layer 12 and the resist layer 13 is small, and it is possible to measure the center of the two alignment marks with precision because both marks are within the range of the depth of focus. However, if the alignment marks are those as shown in FIG.2B, the measurement accuracy may deteriorate because the difference in height is large and both marks are not within the range of the depth of focus at the same time. Since the first process layer 12 is not high, it is difficult to distinguish the first process layer 12 itself, and the measurement of the mark center with high precision is impossible. This applies to FIG.2C where it is also difficult to measure the mark center with high precision.

A method to pick up images at different focal points has been disclosed in Japanese Unexamined Patent Publication (Kokai) No.9-287916. It is necessary, however, to move the objective or semiconductor wafer relatively along the optical axis to pick up images at different focal points. Actually, the edge is detected from the image obtained by adjusting the focal point in the optical system according to the difference in height of the alignment marks, and the coordinates of the mark center are calculated. This process is repeated after the focal point is changed or by scanning along the optical axis. Moreover, it is necessary to do the same process for plural marks of each die, or marks of plural points of a wafer.

In the manufacture of semiconductor device, throughput is an essential factor. In the method disclosed in Japanese Unexamined Patent Publication (Kokai) No. 9-287916, it is necessary to change the focal point in the optical system and a problem, that more time is required for the measurement of the alignment mark, occurs.

A semiconductor wafer inspection machine to measure, with high precision, the error in position of the alignment marks on a semiconductor wafer, which is difficult to measure, as shown in FIG.2C, has been disclosed in Japanese Registered Utility Model No. 3003842. It is necessary, however, for the disclosed inspection machine to scan along the optical axis and problems, that more time is required for the measurement of the alignment mark and that the throughput is deteriorated, occur.

### SUMMARY OF THE INVENTION

The present invention has been developed to solve these problems and the purpose is to realize a semiconductor wafer inspection machine which can measure the alignment marks at different focal points with high precision in less time without causing the throughput to deteriorate.

To realize the above-mentioned purpose, the semiconductor wafer inspection machine of the present invention employs a confocal optical system in which the focal point differs according to the wavelength (or color), and also employs an optical system with wide depth of focus so that clear images can be obtained over a wide range of the focal points and images at different focal points are formed at the same time.

In other words, the semiconductor wafer inspection machine of the present invention forms an optical image of the surface of a semiconductor wafer, in which the first layer having the first alignment mark and the second layer having the second alignment mark are formed, and is characterized in that it is equipped with a confocal optical system in which an optical image of the surface of a semiconductor wafer is formed and the focal point differs for different wavelengths, and that the light source of the confocal optical system has a wide range of wavelengths.

In a confocal optical system, only the image at the focal point is projected clearly and other images out of focus are excluded. Therefore, if the confocal optical system is designed so that the focal point differs depending on wavelength, the image at each focal point corresponding to wavelength is formed clearly. If a light source with a wide range of wavelength is used, a clear image at each focal point is obtained successively, and as a result, clear images over a wide focus range can be obtained. That is, clear images in a wide range of depth of focus can be obtained. It is preferable that the size of an image remains the same even if the focal point is different. For example, a telecentric optical system is recommended for the confocal optical system.

The first layer and the second layer can be contiguous or separated.

Consequently, the focal point of the image formed in the confocal optical system differs depending on wavelength. The wavelength is not limited to visible light, but ultraviolet light or near infrared light can be included.

An image pickup apparatus is provided to convert the optical image of the surface of a semiconductor wafer formed in the confocal optical system into an image signal. If a monochrome TV camera, which has a wavelength sensitivity range corresponding to the wavelength range of the light source, is used as an image pickup apparatus, clear images over a wide range of focal points can be obtained. Therefore, it is possible to measure the accurate center of the alignment marks such as shown in (2) or (3) in FIG.2.

If a color TV camera is used as an image pickup apparatus and the color image signal put out by the color TV camera is displayed in a color display, the image at each focal point is displayed in a different color. This applies when a spinning disk, which is described later, is observed with the naked eye through an eyepiece without using an image pickup apparatus.

When displaying each image signal of the color image pickup apparatus in a color display, it is not necessary to match the color filter characteristics of the color image pickup apparatus to the displayed color. For example, a small difference in wavelength (color) of the color filter of the color image pickup apparatus can be displayed as a marked difference in wavelength (color) to enhance the difference in the displayed image.

When measuring the error in position of the first layer and the second layer automatically, it is necessary to provide an image processor, which can calculate the positions of the first and second alignment marks using the image signal put out of the image pickup apparatus, and the error in position of the first and second layers using those results. In this case, when a monochrome TV camera is used as an image pickup apparatus, the image signal can be processed as is, and when a color TV camera is used as an image pickup apparatus, it is necessary only to process the simple sum of each color image signal.

If the wavelength of an optical image is limited to one of a predetermined range of wavelengths, the focal point, that is, the position along the optical axis can be determined. Therefore, it is also possible to obtain the three-dimensional shape of an alignment mark using this method. In this case, it is necessary to provide an image splitting device that divides an optical image formed in the confocal optical system into the two split optical images with a different wavelength component, and the pickup apparatus needs to generate two image signals corresponding to each split optical image, respectively. It is then required that the wavelength components of the two split optical images overlap each other at least at a part, the ratio of the two image signals changes monotonically in the wavelength range in which the two components overlap, each has an opposite change characteristic, and an image processor, which can calculate the height of the mark from the ratio between the two image signals at the same position, is provided. Since the images at the focal points corresponding to the wavelengths in the overlapped range are included in both two split optical images, and the intensity ratio of the two image signals is determined by the total wavelength characteristics (light source, filter, wavelength characteristics of the image pickup apparatus), the wavelength can be determined by the intensity ratio of the two detected image signals and the focal point can also be determined. Therefore, a three-dimensional shape can be thus obtained.

### BRIEF DESCRIPTION OF THE DRAWINGS

The features and advantages of the invention will be more clearly understood from the following description taken in conjunction with the accompanying drawings, in which:
FIGs.1A and 1B are examples of alignment marks formed on a semiconductor wafer;
FIGs.2A through 2C are cross sections of various alignment marks;
FIGs.3A and 3B illustrate the principle of the confocal optical system and the difference in optical point depending on wavelength;
FIG.4 illustrates the configuration of the semiconductor wafer inspection machine in the first embodiment of the present invention;
FIG.5 is an example of the configuration of a three-plate type TV camera used in the modified example of the first embodiment;
FIG.6 illustrates the configuration of the semiconductor wafer inspection machine in the second embodiment of the present invention; and
FIGs.7A and 7B illustrate the total spectral sensitivity and ratio of the two image signals obtained in the second embodiment.

### DESCRIPTION OF THE PREFERRED EMBODIMENTS

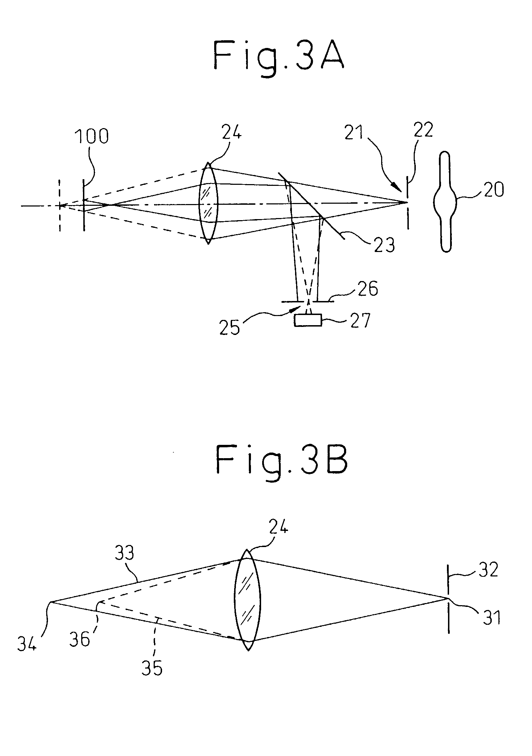

Before the explanation of the embodiments of the present invention is given, the principle of the confocal optical system and the difference in focal point depending on wavelength are explained with FIGs.3A and 3B referenced.

As shown in FIG.3A, a light shielding plate 22 having a pinhole 21 is illuminated by a light source 20. The light rays from the pinhole 21 are directed through a half mirror (half-silvered mirror) to a lens 24, and converged onto a specimen 100 (semiconductor wafer). When the specimen 100 is positioned at the point indicated by a dotted line, the light rays are converged onto the specimen 100 and only a point is illuminated. The light rays reflected by the specimen 100 are directed along the path indicated by a dotted line back to the lens 24, reflected by the half mirror 23, and converged to a pinhole 25 of a light shielding plate 26. Therefore, almost all light rays reflected by the specimen 100 are directed through the pinhole 25 to a light receiver device 27 provided behind the pinhole 25. The pinholes 21 and 25 are positioned so that they are symmetric with respect to the half mirror 23.

When the specimen 100 moves to the position indicated by a solid line, the light rays are converged onto the specimen 100 as a large spot, and the light rays reflected by the specimen 100 are directed back to the lens 24 through the path indicated by a solid line and converged at the pinhole 25 of the light shielding plate 26 as a large spot after being reflected by the half mirror 23. Therefore, a very small number of light rays, which are reflected by the specimen 100, are directed through the pinhole 25 and almost all light rays are blocked by the light shielding plate 25 and not directed to the light receiver 27. That is, the light rays reflected from the specimen 100, which are out of focus, are blocked.

The image of the specimen surface is obtained by moving the pinholes 21 and 25 so that the specimen surface is scanned in a plane perpendicular to the light axis and by combining the outputs of the light receiver 27 at each scanned position. As mentioned above, an image can be obtained when the specimen surface is at the focal point, but not if the specimen surface is out of focus. In the confocal optical system, a clear image can be obtained only at the focal point, and images from any point out of focus are excluded. In FIG.3A, though the pinholes 21 and 25 are positioned so that they are symmetric with respect to the half mirror 23, it is also acceptable that only the pinhole 21 is provided, and not the half mirror. In this case, the half mirror is provided behind the pinhole 21 so that the light source and the light receiver are symmetric with respect to the half mirror. FIG.3 illustrates this case in which the light rays from a pinhole 31 are converged at a point 34, then reflected thereby and directed through the pinhole 31 again.

In general, an optical lens has a chromatic aberration and the focal point differs depending on wavelength. Therefore, when a light source such as a white light source, the wavelength range of which is wide, is used, an apochromatic (or achromatic) lens, which is corrected for chromatic aberrations, is used. A conventional inspection machine to measure the error in position of alignment marks employs a chromatic objective not corrected for chromatic aberrations when a comparably monochromatic light source is used, but it employs an achromatic objective when a white light source is used. If a chromatic objective is employed for a white light source, images with much chromatic aberration are obtained.

Now we consider a case in which a chromatic objective with much chromatic aberration is used in the confocal optical system. As shown in FIG.3B, the objective 24 converges the light of a long wavelength (red) radiated from the pinhole 31 of a light shielding plate 32 onto the point 34 through a path 33 indicated by a solid line, and the light of a short wavelength (blue) onto a point 36 through a path 35 indicated a dotted line. If the specimen surface is placed at the position of the point 34, the light of a long wavelength reflected by the specimen is reflected thereby and converged at the pinhole 31 and most of the light rays are directed through the pinhole 31, but the light of a short wavelength is projected on the light shielding plate 32 as a large spot and most of the light rays are blocked by the light shielding plate 32 and not directed through the pinhole 31. Similarly, if the specimen surface is placed at the position of the point 36, the light of a short wavelength reflected by the specimen is reflected thereby and converged at the pinhole 31, and most of the light rays are directed through the pinhole 31, but the light of a long wavelength is projected on the light shielding plate 32 as a large spot and most of the light rays are blocked by the light shielding plate 32 and not directed through the pinhole 31. That is, among the light rays, which are directed through the pinhole 31, the light rays of a long wavelength form an image of the object at the point 34, and the light rays of a short wavelength form an image of the object at the point 36. The long wavelength light forms the image only at the point 34 and another image at the different point (focal point at the point 36) is excluded. Similarly, the short wavelength light forms the image only at the point 36 and another image at the different point (focal point at the point 34) is excluded. As shown above, if a chromatic objective with much chromatic aberration and a white light source are used in the confocal optical system, the image at each focal point can be obtained successively according to the wavelength. The relation between the wavelengths and the focal points is determined by the chromatic aberration of the chromatic objective, that is, the relation between the wavelengths and the focal points of the chromatic objective.

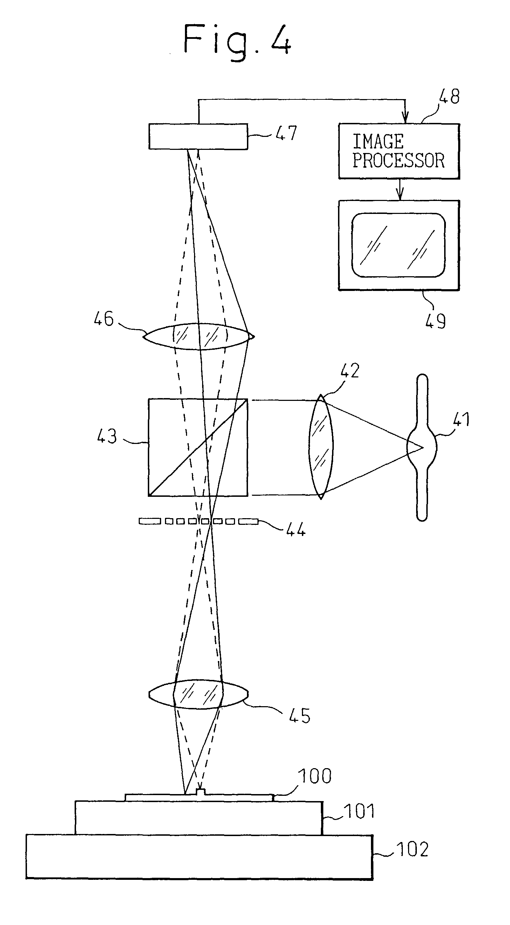

FIG.4 illustrates the configuration of the semiconductor wafer inspection machine in the first embodiment of the present invention. Patterns of different heights are formed on the semiconductor wafer 100. The semiconductor wafer 100 is adhered to a stage 101 and supported while being allowed to move against a base 102. Light source 41 is a white light source that radiates light in a wide range of wavelengths. The light radiated from the light source 41 is collimated by a collimator lens 42, reflected being after directed to a beam splitter 43, and radiated onto a spinning disk 44 having many pinholes. The light rays, which are directed through the spinning disk 44, are converged onto the semiconductor wafer 100 by an objective 45. The objective 45 has a chromatic aberration and the focal point with respect to the spinning disk differs depending on wavelength. For example, light with a long wavelength has a focal plane at a height corresponding to a lower surface of the semiconductor ware, and that with a short wavelength has it at a height corresponding to a higher surface. Therefore, among the light that has passed through the pinhole, the light with a long wavelength is converged to a lower surface of the semiconductor wafer as shown by a solid line, and the light with a short wavelength is converged to a higher surface of the semiconductor wafer as shown by a dotted line. In the light, that has been reflected by the semiconductor wafer 100, the light of a long wavelength, reflected by a lower part is converged at the pinhole of the spinning disk again and directed through the pinhole. But the light of a short wavelength reflected by a lower part is blocked. Similarly, the light of a short wavelength reflected by a higher part is directed through the pinhole, but the light of a long wavelength reflected by a higher part is blocked. Then, the spinning disk 44 revolves and the pinhole scans the surface of the semiconductor 100.

The light that passes through the pinhole is directed through the beam splitter to an achromatic projection lens without color aberrations, and projected onto the screen of a monochrome TV camera 47 having wide wavelength sensitivity characteristics. As shown in FIGs.3A and 3B, among images projected to the monochrome TV camera 47, the clear image of the lower surface of the wafer 100 is formed by the light of a long wavelength, that of the higher surface, by the light of a short wavelength, that of the middle surface, by the light of a medium wavelength, and the monochrome TV camera 47 converts these into image signals and outputs them. Therefore, these image signals can generate clear images in a wide range of focal points from the lower surface to the higher surface of the wafer 100.

The image signal output by the monochrome TV camera 47 is sent to the image processor 48 and is subjected to various processes such as measuring the center of the alignment marks, and at the same time it is displayed in the display 49. The image processor distinguishes the first and second alignment marks from the image signal and calculates the positions, and it also calculates the error in position between the first and second layers using the calculated positions of the first and second alignment marks.

In the confocal optical system in the first embodiment, for example, even if a lens, the depth of focus of which is 0.2 µm or less for a single wavelength, is used, the difference between focal points is 2µm or more in the range of visible light due to the characteristics of the diameter of the pinhole of the spinning disk 44 and the color aberration of the objective 45. This means that, a clear image formed by light of nearly a single wavelength, the width of which is narrow (approx. 35 nm), can be obtained in the range of 2µm or more of the depth of focus. Therefore, the two alignment marks, the difference in height between them being large as shown in FIGs.2B and 2C, are displayed clearly, enabling accurate measurement of the center.

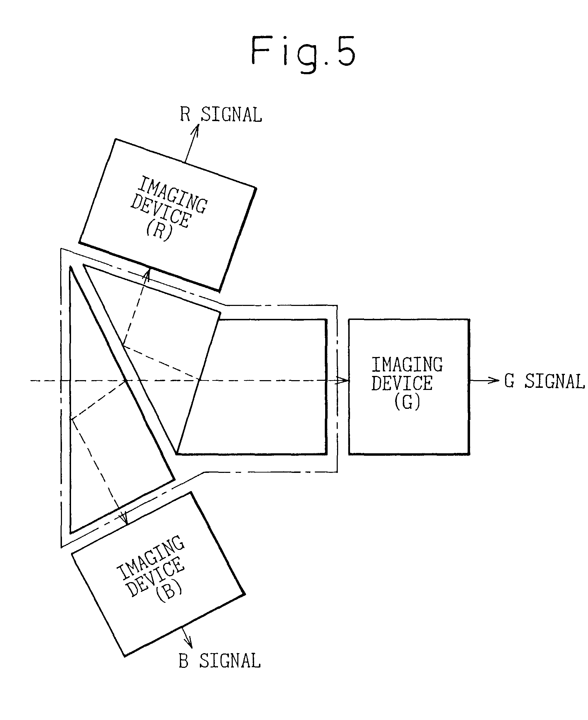

In the first embodiment, the monochrome TV camera 47 is used as an image pickup apparatus, but a color TV camera can be used instead of the monochrome TV camera 47. In this case, it is preferable that the color TV camera to be used is that of three-plate type as shown in FIG.5. The three-plate color TV camera divides an optical image into three optical images of the three colors (RGB) by a prism, on the surface of which a color separation filter is formed, and converts each divided image into an electric signal by three image pickup devices. Though a detailed explanation is omitted here because it is widely known, the three-plate type color TV camera can homogeneously maintain the physical relation between each pixel of the three images and be used for the measurement of position.

The RGB color image signals put out of a color TV camera are shown in a color display. The image of the lower part of the semiconductor wafer surface is displayed in red, that of the higher part, in blue, and the image of a height level between above-mentioned two parts is displayed in a color between red and blue. Therefore, it is easy to distinguish the higher and lower parts by the image in the display. Moreover, it is possible to show the difference in height in predetermined colors by an image processor, without showing the RGB color image signals output by the color TV camera. For example, if the signals are processed so that each focal point corresponding to blue-green and green is shown in blue and red, respectively, the small difference in height is enhanced to facilitate the distinction.

When processing the RGB image signals, output by the color TV camera, by the image processor, and calculating the difference between the centers of the alignment marks automatically, it is possible to employ a similar process when using a monochrome TV camera, by processing the signal, which is just a sum of each color image signal. Furthermore, since the color of an image corresponds to the focal point, it is possible to determine the three-dimensional shape using the colors of the image. The second embodiment described below shows an example when determining the three-dimensional shape by the colors (wavelengths) of images.

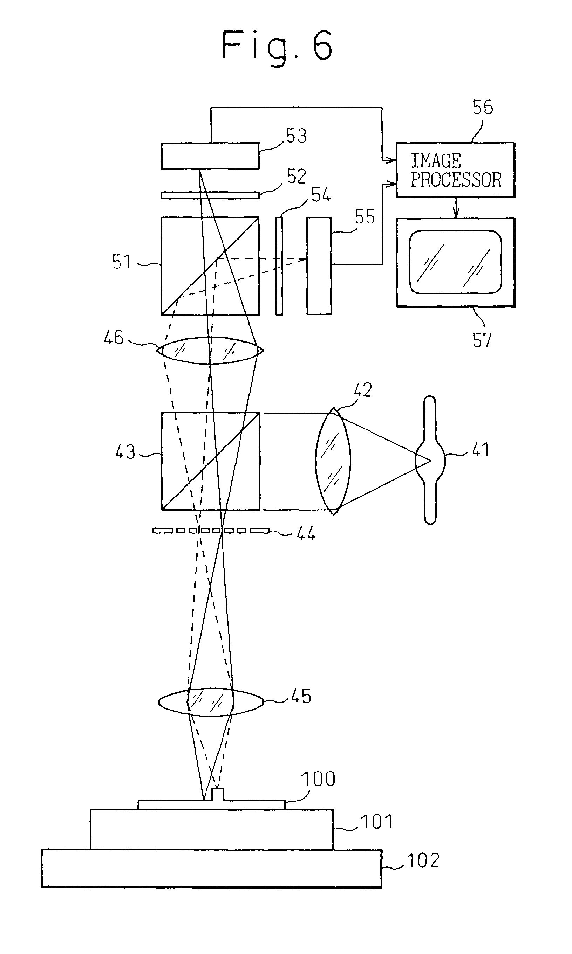

FIG.6 illustrates the configuration of the semiconductor wafer inspection machine in the second embodiment of the present invention. When compared to FIG.4, it is clear that the configuration in the second embodiment differs from that in the first embodiment in the part of the image pickup apparatus after the projection lens 46.

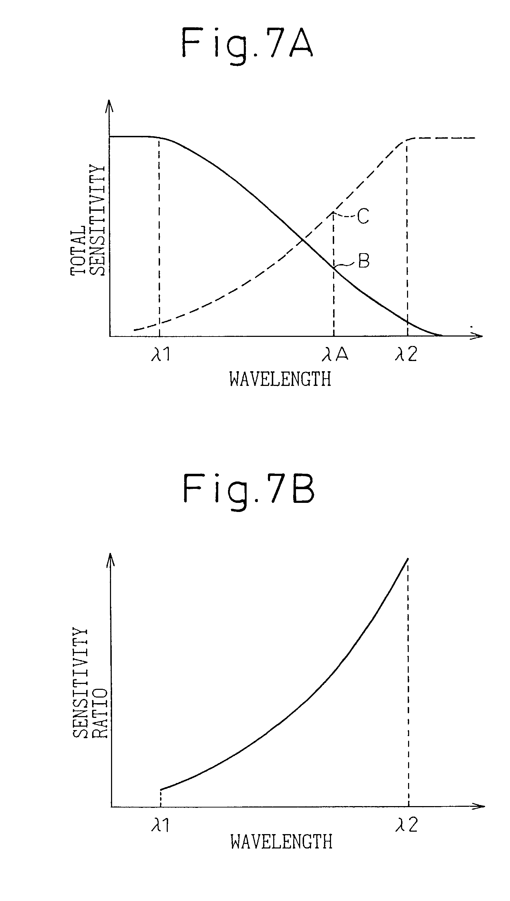

The light directed through the projection lens 46 is separated into two optical images by a beam splitter 51, each image is directed through color filters 52 and 54 with different wavelength characteristics, respectively, and projected on the screen of a monochrome TV cameras 53 and 55 to generate image signals. The image signals output by the monochrome TV cameras 53 and 55 are supplied to an image processor, processed therein, and shown on a display 57. The wavelength characteristics are determined by the spectral characteristics of the light source 41, the wavelength characteristics of the color filters 52 and 54, and the total spectral sensitivity of both the monochrome TV cameras 53 and 55. In the second embodiment, the wavelength characteristics of the color filters 52 and 54 are selected so that the total spectral sensitivity (total sensitivity) has the wavelength characteristics shown with a solid line and a dotted line in FIG.7A. That is, the two total sensitivity intersects each other between λ1 and λ2, one of the total sensitivity is high when the wavelength is shorter than λ1 and decreases gradually so that it is low when the wavelength is λ2 as shown with a solid line, and the other, as shown with a dotted line, is low when the wavelength is λ1 and increases so that it is high when the wavelength is longer than λ2. Such total sensitivity can be realized, for example, if the light source 41, the monochrome TV cameras, and the color filters 52 and 54 are selected as follows. The light source 41 has the same intensity for a wavelength between λ1 and λ2, the monochrome TV cameras 53 and 55 have the same sensitivity for a wavelength between λ1 and λ2, the permeability of the color filter 52 is high for a wavelength shorter than λ1 and decreases gradually so that it is low when the wavelength is equal to λ2, and the permeability of the color filter 54 is low when the wavelength is equal to λ1 and increases gradually and is high for a wavelength longer than λ2.

When the total sensitivity of the two image signals has the characteristics as shown in FIG.7A, the spectral sensitivity ratio of the two image signals increases monotonically between λ1 and λ2 as shown in FIG.7B. For example, it is assumed that the surface of the semiconductor wafer is at the focal point corresponding to the wavelength represented by λA in FIG.7. The main wavelength of the optical image of this surface is represented by λA, and the intensity ratio of the signals put out of the monochrome TV cameras 53 and 55 is the ratio of B to C. Though the absolute values differ depending on the reflectance of the surface, the ratio is constant. Therefore, if we calculate the intensity ratio of the two signals and find the wavelength, which satisfies the sensitivity ratio from FIG.7B, we can calculate the main wavelength of the optical image of that part, and the height of the surface (focal point). Therefore, if we calculate the height of that part using the intensity ratio of the two signals, we can obtain the three-dimensional shape of the surface.

The ranges of the detected wavelengths of the color TV camera RGB image signals overlap each other, and, for example, it is possible to calculate the three-dimensional shape by applying the method of the second embodiment to the pairs of image signals of R and G, and G and B. In this case, the pair of R and G signals is used for the components of the wavelength longer than the center wavelength of G (approx. 500 nm), and the pair of G and B signals, for those shorter than the center wavelength of G.

The alignment marks are marks that indicate the difference in height, and it is possible to measure the position of the center more accurately by obtaining the three-dimensional shape. For example, each edge is not always the same for the same mark, but one edge may be steep, while the other edge may be gradual. In the case of a gradual edge, the center position of a mark depends on which part of the edge is determined as the center position of the edge. If the three-dimensional shape is obtained, it is possible to specify a height that is used to determine the center position of the edge and measure the position of the mark more accurately.

Though the embodiments of the present invention are explained as above as an independent device, this invention can be used in circumstances such as where it is built in or attached to an exposure apparatus or a manufacturing machine.

As explained above, according to the present invention, it is possible to generate clear images at plural focal points at the same time without varying the focal point along the optical axis, and to measure the error between the alignment marks of the semiconductor wafer speedily and accurately.

## Claims

1. A semiconductor wafer inspection machine that forms an optical image of the surface of a semiconductor wafer, on which a first layer having a first alignment mark and a second layer having a second alignment mark are formed, comprising a confocal optical system, in which the focal point differs depending on wavelength and an optical image of the surface of the semiconductor wafer is formed, and a light source of the confocal optical system having a wide range of wavelengths.

2. A semiconductor wafer inspection machine, as set forth in claim 1, wherein an image pickup apparatus, which converts the optical image of the semiconductor wafer formed in the confocal optical system into an image signal, is provided.

3. A semiconductor wafer inspection machine as set forth in claim 2, wherein the image pickup apparatus is a monochrome TV camera.

4. A semiconductor wafer inspection machine as set forth in claim 2, wherein the image pickup apparatus is a color TV camera.

5. A semiconductor wafer inspection machine as set forth in claim 2, wherein an image processor, which calculates the positions of the first alignment mark and the second alignment mark using the image signals output by the image pickup apparatus and, based on the result, calculates further the error in position between the first layer and the second layer, is provided.

6. A semiconductor wafer inspection machine as set forth in claim 2, wherein an image splitter, which divides the optical image formed in the confocal optical system into two split optical images with a different wavelength, is provided and the image pickup apparatus generates two image signals corresponding to each split optical image, respectively.

7. A semiconductor wafer inspection machine as set forth in claim 6, wherein the wavelength components of the two split optical images overlap each other at least at a part, and the ratio between the two image signals changes monotonically and the characteristics of change are opposite in the range in which the wavelength components overlap each other; and said machine includes an image processor, which calculates the height of the relevant part based on the ratio between the two image signals corresponding to the same part.
